# EUROPEAN PATENT SPECIFICATION

(11) **EP 2 943 986 B1**
(45) Date of publication and mention of the grant of the patent: **01.03.2023**
(21) Application number: 14701126.6
(22) Date of filing: 06.01.2014
(51) Int. Cl.: H01L 33/00, H01L 33/20, H01L 33/46

(54) **LED WITH SHAPED GROWTH SUBSTRATE FOR SIDE EMISSION AND METHOD OF ITS FABRICATION**
LEUCHTDIODE MIT AUSGEFORMTEM AUFWACHSSUBSTRAT ZUR HORIZONTALEMISSION UND VERFAHREN ZU SEINER HERSTELLUNG
DIODE ÉLECTRO-LUMINESCENTE À SUBSTRAT DE CROISSANCE FORMÉ POUR ÉMISSION HORIZONTALE ET PROCÉDÉ DE SA FABRICATION

(30) Priority: 10.01.2013 US 201361750914 P
(43) Date of publication of application: 18.11.2015
(73) Proprietor: Lumileds LLC, San Jose, CA 95131 (US)
(72) Inventor: BUTTERWORTH, Mark Melvin, 5656 AE Eindhoven (NL)
(74) Representative: Cohausz & Florack
(86) International application number: PCT/IB2014/058077
(87) International publication number: WO 2014/108821

(56) References cited:
- EP-A1- 1 225 643
- EP-A2- 1 367 656
- DE-A1-102004 046 994
- JP-A- H03 227 078
- JP-A- H07 263 743
- JP-A- H11 330 565
- JP-A- S61 127 186
- US-A1- 2003 127 654
- US-A1- 2009 008 666
- US-A1- 2009 045 416
- US-A1- 2011 018 020
- US-A1- 2012 280 261

## Description

### FIELD OF THE INVENTION

This invention relates to light emitting diodes (LEDs) and, in particular, to a technique for causing an LED to have enhanced side emission.

### BACKGROUND

A vast majority of all light emitted from an LED die is from its top surface, opposite the LED's mounting surface. This essentially creates a pin point of light, since the top surface area is on the order of 1 mm².

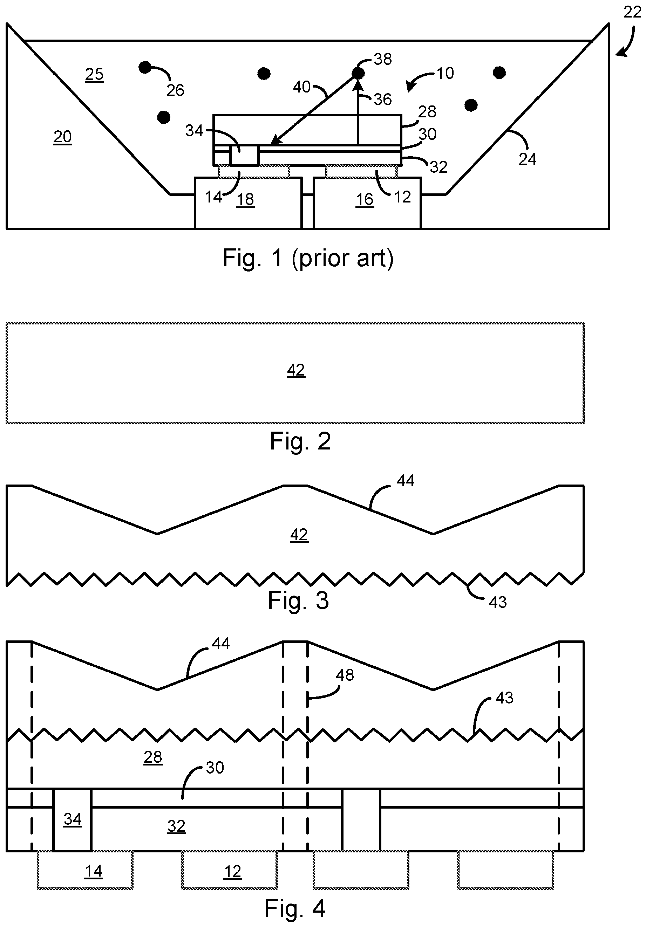

Fig. 1 represents a common use for an LED, where the LED is located in a reflective cup for directing light in a particular direction, such as for an LED flash in a smartphone camera. Fig. 1 is a cross-sectional view of a typical flip-chip LED die 10 having its anode contact 12 and its cathode contact 14 formed on the bottom surface of the die 10. The contacts 12 and 14 take up a large area of the bottom surface of the LED die 10 and are reflective. The die 10 may optionally be mounted on a submount having more robust metal pads for bonding to the electrodes of a package 20.

The contacts 12 and 14 are bonded to electrodes 16 and 18 in a package 20. The package electrodes 16 and 18 may then be connected to any other terminals, such as to metal pads on a printed circuit board, a substrate, elongated pins for insertion into a socket, etc.

The LED die 10 is located in a reflective cup 22. The reflective walls 24 of the reflective cup 22 may be coated with a reflective metal or paint, or the cup 22 itself may be formed of a reflective material.

The LED die 10 may be GaN based and emit blue light. The cup 22 is filled with a material comprising phosphor powder 26 infused in silicone, epoxy, or other encapsulating binder material 25. The phosphor powder 26 may be YAG (emits yellow-green light), or a mixture or red and green phosphor powders, or any other type of phosphor(s). Some blue light escapes, and the resulting mixture of blue light and phosphor light create white light or any other color of light, depending on the phosphor type and density of the phosphor.

The LED die 10, in its simplified example of Fig. 1, has an n-type semiconductor layer 28, an active layer 30, and a p-type semiconductor layer 32. There are typically many other layers in a heterojunction GaN LED. The LED layers are epitaxially grown over a growth substrate. A conductor 34 extends through the p-type semiconductor layer 32 and active layer 30 to connect the cathode contact 14 to the n-type semiconductor layer 28. In the example of Fig. 1, the growth substrate, such as sapphire, has been removed.

Generally, the LED die 10 absorbs about 15% of the visible light that impinges on it. In the example of Fig. 1, a blue light ray 36 from the LED die 10 energizes a particular grain 38 of the phosphor powder 26, and the light (e.g., yellow light) emitted from the grain 38 is emitted in all directions. One of the emitted rays 40 is shown coming back toward the LED die 10, where about 15% of the light is absorbed by the LED die 10.

Since the vast majority of all light emitted by the LED die 10 is through its top surface, and almost half of the light emitted by the phosphor above the LED die 10 is downward toward the LED die 10, there is a significant amount of light absorbed by the LED die 10, lowering the efficiency of the LED module.

EP 1 367 656 A2 discloses a semiconductor light emitting element having a reflecting surface on a side opposite to a main light emitting surface of the semiconductor light emitting element. The reflecting surface is in the substrate and inclined with respect to the semiconductor layers.

US 2009/045416 A1 discloses a side emitting semiconductor light emitting element with an reflector parallel to the top surface of the semiconductor light emitting element.

What is needed is an inexpensive technique for improving the efficiency of LED modules, such as an LED die in a reflective cup.

### SUMMARY

The light emitting structure of the invention is defined in claim 1 and the method of forming the light emitting structure is defined in claim 11.

In one embodiment, a transparent growth substrate wafer, such as sapphire, SiC, GaN, or other growth substrate wafer is patterned, by masking and etching or any other suitable method, to have optical features with angled sides that reflect a majority of the LED light sideways so that a majority of the LED light is emitted from the sidewalls of the LED. The optical features are formed opposite the growth surface (i.e., on the outside of the complete LED). A reflective layer is deposited over the growth substrate wafer to coat the outer surface of the optical features. Since there may be many thousands of LEDs grown on a single growth substrate wafer, there will be thousands of the optical features formed in the substrate. In one embodiment, the optical features are concave cones or dimples having a vertex approximately centered with respect to its associated LED. Other optical feature shapes are also envisioned.

The growth substrate wafer is preferably much thicker than a conventional growth substrate wafer. For example, conventional growth substrate wafers are typically less than 100 microns (ideally, the minimum thickness to achieve the desired mechanical support during processing). To achieve the desired depths of the optical features (e.g., cones) and to create a relatively large surface area for the sidewalls, the growth substrate wafer may be greater than twice the thickness of a conventional growth substrate wafer, such as 0.5 mm-1 mm.

The angled sides of the optical features may reflect the LED light by total internal reflection (TIR), or a thin reflective metal layer may be deposited over the growth substrate wafer to coat the outer surface of the optical features. The etching of the growth substrate wafer is preferably performed prior to the LED semiconductor layers being grown to avoid damage to the LEDs. It will be assumed that the LED is a GaN based LED emitting blue light or ultraviolet light. After the LEDs are formed over the growth substrate wafer, the wafer is singulated to form individual side-emitting LED dies.

Accordingly, a majority of all the light emitted by the LED die's active layer will be reflected sideways by the optical features.

According to the invention the resulting LED die is mounted in a reflective cup, and the cup is filled with a phosphor material. The phosphor grains that are energized by the blue light will not be over the LED die, but will be over a reflective surface of the cup. Therefore, when the grains emit light in all directions, a smaller percentage of the phosphor light will impinge on the active layer and be absorbed by the LED and a larger percentage will be reflected upward by the cup's reflective walls surface. This greatly increases the light output of the LED module and improves efficiency with very little additional cost.

The invention is not limited to flip-chip LEDs, and vertical LEDs or LEDs with top contacts may be used instead of flip-chip LEDs.

It is known to create a side-emitting LED, such as for use in backlights, by affixing a separate side-emitting lens over the top of an LED die. However, the present technique obviates such a side-emitting lens. Since no separate side-emitting lens is used, the cost for the lenses and extra processing steps are avoided, and the LED module can be made shallower. Reflecting the LED light using optical features in the growth substrate is also more optically efficient than using a side-emitting lens.

Various other embodiments are disclosed.

### BRIEF DESCRIPTION OF THE DRAWINGS

Fig. 1 is a cross-sectional simplified view of a prior art blue or UV flip-chip LED die mounted in a reflective cup filled with a phosphor material.
Fig. 2 is a cross-sectional view of a small portion of a relatively thick transparent growth substrate wafer.
Fig. 3 illustrates the wafer of Fig. 2 after the bottom surface is roughened to improve light extraction and after the top surface is formed to have optical features to cause the LED to be a side-emitting LED.
Fig. 4 is a cross-sectional view of two simplified LEDs formed on the growth substrate wafer of Fig. 3.
Fig. 5 is a cross-sectional view of the light emitting structure according to the invention, comprising a singulated LED die mounted in a reflective cup filled with a phosphor material, where the phosphor grains emit light away from the top surface of the LED die to reduce the amount of absorption by the LED die.
Fig. 6 illustrates the structure of Fig. 5 but with the addition of an LED submount.
Fig. 7 is a cross-sectional view of another embodiment of an LED die, where the optical feature formed in the growth substrate has a bowl or parabolic shape.
Fig. 8 is a cross-sectional view of another embodiment of an LED die, where the optical feature formed in the growth substrate has a dome shape for refracting light away from over the top surface of the LED die.

Elements that are the same or similar are labeled with the same numeral.

### DETAILED DESCRIPTION

The present inventive technique may be applicable to many types of different LEDs, and one example of an LED structure will be described to illustrate the invention's application. In the example, the LED is a GaN based LED that emits blue light. A suitable transparent growth substrate for a GaN based LED is typically sapphire, SiC, or GaN.

Fig. 2 illustrates a sapphire growth substrate wafer 42. Such wafers are available between 2-6 inches in diameter, although larger wafers are anticipated and included within the scope of the invention. Since a typical LED is only about 1 mm², many thousands of LEDs may be formed on a single wafer 42. The conventional thickness of such a wafer is less than 100 microns, or what the manufacturer believes is the minimum thickness needed for mechanical support of the LED layers during processing. However, in the present process, a much thicker wafer 42 is used to accommodate the depth of the side-emitting optical features and to create a large sidewall surface area. In one embodiment, the thickness of the wafer 42 is about 0.3 mm-1 mm, and preferably greater than 0.5 mm.

The bottom surface 43 (the GaN growth surface) of the wafer 42 is roughened to increase light extraction by reducing total internal reflection (TIR). Such roughening is conventional and may be performed by grinding, chemical etching, plasma etching, etc.

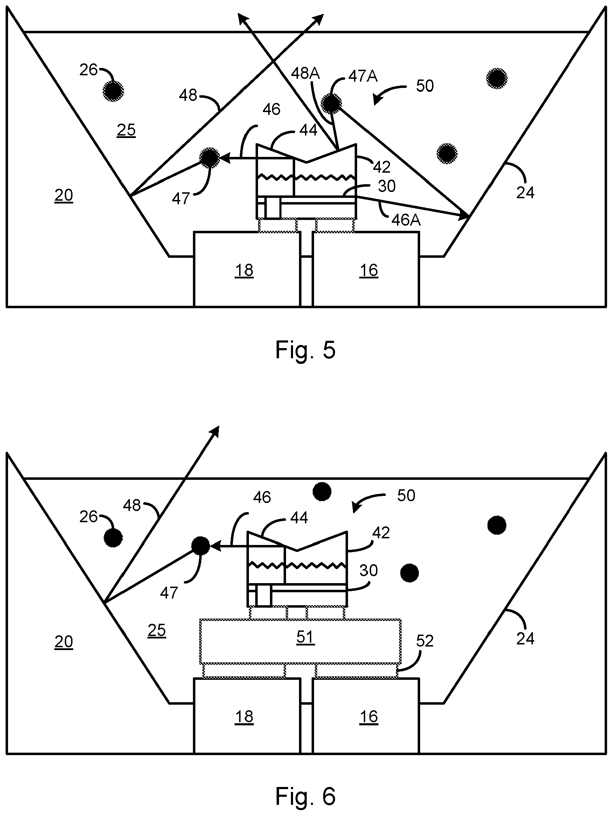

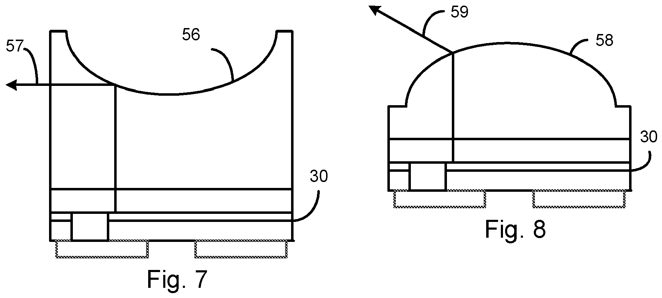

In one embodiment, the top surface of the wafer 42 is masked, using a metal (Ni) mask or a photoresist mask, and chemically etched to form thousands of optical features 44, one for each LED to be formed. In one embodiment, the wafer 42 surface is patterned with a Ni mask and a chlorine-based inductively coupled plasma-RIE process is used to form conical optical features. The thickness of the Ni mask creates a shadow effect near the edges of each mask opening so that the etching rate progressively diminishes towards the edges of the Ni openings. Etching features in sapphire is known. A laser or grinding tool may also be used to etch the wafer 42. A cross section of a conical optical feature 44 is shown in Fig. 3 although many other suitable features may be formed. Figs. 6 and 7 illustrate some other optical features.

The depth of the optical features 44 may exceed one half the width of the singulated LED for a 45 degree angle cone to achieve a wide TIR angle. For example, the depth of the cone may be about 0.5 mm. Other shapes of optical features may be made shallower and utilize a thinner wafer 42.

In one embodiment, the reflection by the optical features 44 is by TIR. In another embodiment, a thin layer of reflective metal, such as silver or aluminum, is deposited (e.g., by sputtering) over the optical features 44. The reflective metal may only be a few microns thick. In such a case, the growth substrate wafer 42 may be thinner. Dielectric layers may also be formed as a Bragg reflector over the optical features 44 to act as a mirror.

As shown in Fig. 4, the LED semiconductor layers may then be epitaxially grown over the roughened surface 43 using conventional techniques. Such a GaN based LED may have the same layers 28, 30, and 32 as described with respect to Fig. 1. The metal conductor 34, anode contact 12, and cathode contact 14 are then formed to form a flip-chip LED.

The resulting LED wafer is then singulated by, for example, laser etching or scribing followed by breaking. Singulation lines 48, including the kerf, are shown in Fig. 4. Many suitable ways of singulating an LED wafer are known.

As shown in Fig. 5, according to the invention, the resulting LED dies 50 are mounted in a reflective cup 20, as described with respect to Fig. 1. The bare LED dies 50 may optionally be mounted on a robust submount 51, shown in Fig. 6, prior to be mounted in the cup 20. The submount 51 acts as a heat spreader and provides much larger and robust bottom contacts 52 for attachment to the cup electrodes 16 and 18. Such a submount 51 however adds height and cost to the module.

According to the invention, the cup 20 is then filled with a material comprising phosphor powder 26 infused in a transparent or translucent encapsulant binder material 25 such as silicone or an epoxy. The material 25 is then cured. The type(s) of phosphor powder(s), the density of the phosphor powder 26, and the thickness of the phosphor layer determine the overall color emitted by the combination of the LED light and phosphor light.

As shown in Fig. 5, the optical feature 44 will cause most of the LED light emitted from the active layer 30 to be reflected out the relatively large sidewalls of the LED die 50. Thus, most of the LED die's emitted light will energize phosphor grains that are over the reflective cup surface rather than over the LED die 50. When these grains emit light in all directions, a vast majority of the emitted light will either be emitted upward, out the top surface of the module, or be reflected upwards by the reflective cup. Only a small percentage of the emitted light will impinge the active layer 30 of the LED die 50, where about 15% of the light will be absorbed by the active layer 30. A light ray 46 emitted by the active layer 30 is shown being reflected by the optical feature 44 and energizing a phosphor grain 47, where the grain 47 emits a light ray 48 that is reflected upward by the cup's reflective wall 24.

Additionally, if the top of the wafer 42 is coated with a reflective film, such as a reflective metal, any light emitted by the phosphor grains that impinges on the reflective film will be redirected away from the LED die 50 and not be absorbed. This further increases the efficiency of the structure of Fig. 5. In Fig. 5, this is illustrated by the light ray 46A energizing a phosphor grain 47A, which emits a light ray 48A that reflects off a reflective film on the wafer 42.

Thus, compared to the conventional structure of Fig. 1, there is a large reduction in the absorption of light by the active layer 30, and efficiency is improved at very little additional cost.

The side-emitting LED die 50 is also useful for backlighting liquid crystal displays (LCDs) by more evenly spreading light into a light guide, where the light guide has prisms or a roughened surface for redirecting the light toward the LCD screen. Since the side-emitting LED die is very shallow, the light guide may be very thin. The LED dies may be mounted in holes in the light guide or along its edges.

Many other optical features besides cones may be formed in the growth substrate wafer. For example, a dimple having a vertex and a symmetrical asymptotic or parabolic shape may be used.

Fig. 7 illustrates how the optical feature may be a bowl shape 56, which may be easier to form than a cone shape. Reflection may be by TIR, or a reflective metal may be deposited in the bowl. A reflected light ray 57 is shown.

Fig. 8 illustrates how the optical feature may be a convex dome shape 58. In such a case, the LED light is refracted away from over the LED top surface. A refracted light ray 59 is shown.

In another embodiment, the LED die 50 is not a flip-chip.

In another embodiment, the wavelength conversion material in the reflective cup is While particular embodiments of the present invention have been shown and described, it will be obvious to those skilled in the art that changes and modifications may be made. The scope of the invention is defined by the appended claims.

## Claims

1. A light emitting structure comprising:
a light emitting diode (LED) die (10) comprising:
a growth substrate (42) having a first surface (43) and a second surface (44) opposite the first surface (43);
semiconductor layers (28, 30, 32), including an active layer (30) that emits light, epitaxially grown over the first surface (43) of the growth substrate, the active layer (30) having a third surface facing the growth substrate (42);
a bottom surface; and
reflective anode and cathode electrodes (12, 14) that cover a significant portion of the bottom surface of the LED die (10) and that are configured to be directly connected to electrodes in a package,
wherein the second surface (44) of the growth substrate (42) has formed in it at least one optical feature that redirects at least a portion of the light emitted from the third surface of the active layer (30) to exit the LED die (10) through sidewalls of the growth substrate (42), such that the sidewalls of the growth substrate (42) emit a majority of light generated by the active layer (30),
wherein the at least one optical feature is covered with a reflective layer that reflects the portion of the light emitted from the third surface of the active layer (30) to exit the LED die through the sidewalls of the growth substrate (42),
wherein the light emitting structure further comprises a reflective cup (22) in which the LED die is mounted; and
a wavelength conversion material (25, 26) in the cup covering a top and sides of the LED die (10).

2. The structure of Claim 1 wherein the at least one optical feature has an angled surface that redirects light toward the sidewalls of the growth substrate (42).

3. The structure of Claim 1 wherein the at least one optical feature comprises a concave, substantially conical shape formed in the growth substrate (42).

4. The structure of Claim 1 wherein the at least one optical feature comprises a concave rounded shape formed in the growth substrate (42).

5. The structure of Claim 1 wherein the at least one optical feature comprises a convex rounded shape that refracts the light towards the sidewalls of the growth substrate (42).

6. The structure of Claim 1 wherein the growth substrate (42) comprises sapphire.

7. The structure of Claim 1 wherein the growth substrate (42) is greater than 200 microns thick.

8. The structure of Claim 1 wherein the growth substrate (42) is greater than 500 microns thick.

9. The structure of Claim 1 wherein the wavelength conversion material (26) comprises phosphor grains infused in a binder material, and wherein at least a portion of the light emitted from the sidewalls of the growth substrate (42) energize phosphor grains that are not overlying the LED die (10).

10. The structure of Claim 1, wherein the LED die (10) emits blue light and the phosphor material emits phosphor light that combines with the blue light.

11. A method of forming a light emitting structure comprising:
providing a growth substrate wafer (42) having a first surface (43) and a second surface (44) opposite the first surface (43);
forming a plurality of optical features in the second surface (44) of the growth substrate wafer (42);
after forming the plurality of optical features, growing epitaxial layers (28, 30, 32) over the first surface (43) of the growth substrate wafer to form a light emitting diode (LED), the LED having an active layer (30) that emits light, the active layer (30) having a third surface facing the growth substrate wafer (42);
forming reflective anode (12) and cathode electrodes (14) that cover a significant portion of a bottom surface of the light emitting diode (10) and that are configured to be directly coupled to electrodes of a package;
depositing a reflective layer over the growth substrate wafer (42) to coat the outer surface of the optical features;
singulating the growth substrate wafer (42) to form individual LED dies (10) having a growth substrate portion (42), wherein each growth substrate portion (42) has at least one of the optical features, the least one of the optical features redirecting a majority of light emitted from the third surface of the active layer to exit the LED die (10) through sidewalls of the growth substrate portion (42),
**characterized by**,
mounting one of the LED dies (10) in a reflective cup (22); and
depositing a wavelength conversion material (25, 26) in the cup (22) covering a top and sides of the LED die (10).

## Patentansprüche

1. Lichtemittierende Struktur, umfassend:
einen Leuchtdioden (LED)-Die (10), umfassend:
ein Wachstumssubstrat (42) mit einer ersten Oberfläche (43) und einer zweiten Oberfläche (44) gegenüber der ersten Oberfläche (43);
Halbleiterschichten (28, 30, 32), einschließlich einer aktiven Schicht (30), die Licht emittiert, welche epitaktisch auf der ersten Oberfläche (43) des Wachstumssubstrats aufgewachsen sind, wobei die aktive Schicht (30) eine dritte Oberfläche aufweist, die dem Wachstumssubstrat (42) zugewandt ist;
eine untere Oberfläche; und
reflektierende Anoden- und Kathodenelektroden (12, 14), die einen wesentlichen Teil der unteren Oberfläche des LED-Dies (10) bedecken und die dazu eingerichtet sind, direkt mit Elektroden in einem Gehäuse verbunden zu werden,
wobei die zweite Oberfläche (44) des Wachstumssubstrats (42) in sich ausgebildet mindestens ein optisches Merkmal aufweist, das mindestens einen Teil des von der dritten Oberfläche der aktiven Schicht (30) emittierten Lichts so umlenkt, dass dieser den LED-Die (10) durch Seitenwände des Wachstumssubstrats (42) verlässt, sodass die Seitenwände des Wachstumssubstrats (42) einen Großteil von von der aktiven Schicht (30) erzeugtem Licht emittieren,
wobei das mindestens eine optische Merkmal mit einer reflektierenden Schicht bedeckt ist, die den Teil des von der dritten Oberfläche der aktiven Schicht (30) emittierten Lichts so reflektiert, dass dieser den LED-Die durch die Seitenwände des Wachstumssubstrats (42) verlässt,
wobei die lichtemittierende Struktur ferner eine reflektierende Schale (22), in der der LED-Die angebracht ist; und ein Wellenlängenkonversionsmaterial (25, 26) in der Schale umfasst, welches eine Oberseite und Seiten des LED-Dies (10) bedeckt.

2. Struktur nach Anspruch 1, wobei das mindestens eine optische Merkmal eine gewinkelte Oberfläche aufweist, die Licht in Richtung der Seitenwände des Wachstumssubstrats (42) umlenkt.

3. Struktur nach Anspruch 1, wobei das mindestens eine optische Merkmal eine konkave, im Wesentlichen konische Form umfasst, die in dem Wachstumssubstrat (42) ausgebildet ist.

4. Struktur nach Anspruch 1, wobei das mindestens eine optische Merkmal eine konkave, abgerundete Form umfasst, die in dem Wachstumssubstrat (42) ausgebildet ist.

5. Struktur nach Anspruch 1, wobei das mindestens eine optische Merkmal eine konvexe, abgerundete Form umfasst, die das Licht in Richtung der Seitenwände des Wachstumssubstrats (42) bricht.

6. Struktur nach Anspruch 1, wobei das Wachstumssubstrat (42) Saphir umfasst.

7. Struktur nach Anspruch 1, wobei das Wachstumssubstrat (42) mehr als 200 Mikron dick ist.

8. Struktur nach Anspruch 1, wobei das Wachstumssubstrat (42) mehr als 500 Mikron dick ist.

9. Struktur nach Anspruch 1, wobei das Wellenlängenkonversionsmaterial (26) Phosphorkörner umfasst, die in ein Bindemittelmaterial eingebracht sind, und wobei mindestens ein Teil des von den Seitenwänden des Wachstumssubstrats (42) emittierten Lichts Phosphorkörner anregt, die nicht über dem LED-Die (10) liegen.

10. Struktur nach Anspruch 1, wobei der LED-Die (10) blaues Licht emittiert und das Phosphormaterial Phosphorlicht emittiert, das sich mit dem blauen Licht kombiniert.

11. Verfahren zur Bildung einer lichtemittierenden Struktur, umfassend:
Bereitstellen eines Wachstumssubstratwafers (42) mit einer ersten Oberfläche (43) und einer zweiten Oberfläche (44) gegenüber der ersten Oberfläche (43);
Ausbilden einer Vielzahl optischer Merkmale in der zweiten Oberfläche (44) des Wachstumssubstratwafers (42);
nach dem Ausbilden der Vielzahl optischer Merkmale, Aufwachsen von Epitaxialschichten (28, 30, 32) auf der ersten Oberfläche (43) des Wachstumssubstratwafers, um eine Leuchtdiode (LED) zu bilden, wobei die LED eine aktive Schicht (30) aufweist, die Licht emittiert, wobei die aktive Schicht (30) eine dritte Oberfläche aufweist, die dem Wachstumssubstratwafer (42) zugewandt ist;
Ausbilden reflektierender Anoden- (12) und Kathodenelektroden (14), die einen wesentlichen Teil einer unteren Oberfläche der Leuchtdiode (10) bedecken und die dazu eingerichtet sind, direkt mit Elektroden eines Gehäuses gekoppelt zu werden;
Ablagern einer reflektierenden Schicht über den Wachstumssubstratwafer (42), um die äußere Oberfläche der optischen Merkmale zu beschichten;
Vereinzeln des Wachstumssubstratwafers (42), um einzelne LED-Dies (10) mit einem Wachstumssubstratabschnitt (42) zu bilden, wobei jeder Wachstumssubstratabschnitt (42) mindestens eines der optischen Merkmale aufweist, wobei das mindestens eine der optischen Merkmale einen Großteil von von der dritten Oberfläche der aktiven Schicht emittiertem Licht so umlenkt, dass dieser den LED-Die (10) durch Seitenwände des Wachstumssubstratabschnitts (42) verlässt,
**gekennzeichnet durch**,
Anbringen eines der LED-Dies (10) in einer reflektierenden Schale (22); und
Ablagern eines Wellenlängenkonversionsmaterials (25, 26) in der Schale (22), welches eine Oberseite und Seiten des LED-Dies (10) bedeckt.

## Revendications

1. Structure électroluminescente comprenant :
une matrice à diode électroluminescente (LED) (10) comprenant :
un substrat de croissance (42) ayant une première surface (43) et une deuxième surface (44) opposée à la première surface (43) ;
des couches semi-conductrices (28, 30, 32), comprenant une couche active (30) qui émet de la lumière, formées par épitaxie sur la première surface (43) du substrat de croissance, la couche active (30) ayant une troisième surface faisant face au substrat de croissance (42) ;
une surface inférieure ; et
des électrodes d'anode et de cathode réfléchissantes (12, 14) qui recouvrent une partie significative de la surface inférieure de la matrice LED (10) et qui sont configurées pour être directement connectées à des électrodes dans un boîtier, dans lequel la deuxième surface (44) du substrat de croissance (42) a formé en elle ledit au moins un élément optique qui redirige au moins une partie de la lumière émise depuis la troisième surface de la couche active (30) pour sortir de la matrice LED (10) à travers les parois latérales du substrat de croissance (42), de sorte que les parois latérales du substrat de croissance (42) émettent une majorité de la lumière générée par la couche active (30),
dans lequel ledit au moins un élément optique est recouvert d'une couche réfléchissante qui réfléchit la partie de la lumière émise depuis la troisième surface de la couche active (30) pour sortir de la matrice LED à travers les parois latérales du substrat de croissance (42),
dans lequel
la structure électroluminescente comprend en outre une coupelle réfléchissante (22) dans laquelle la matrice LED est montée ; et
un matériau de conversion de longueur d'onde (25, 26) dans la coupelle recouvrant un dessus et des côtés de la matrice LED (10).

2. Structure selon la revendication 1, dans laquelle ledit au moins un élément optique a une surface inclinée qui redirige la lumière vers les parois latérales du substrat de croissance (42).

3. Structure selon la revendication 1, dans laquelle ledit au moins un élément optique comprend une forme concave sensiblement conique formée dans le substrat de croissance (42).

4. Structure selon la revendication 1, dans laquelle ledit au moins un élément optique comprend une forme arrondie concave formée dans le substrat de croissance (42).

5. Structure selon la revendication 1, dans laquelle ledit au moins un élément optique comprend une forme arrondie convexe qui réfracte la lumière vers les parois latérales du substrat de croissance (42).

6. Structure selon la revendication 1, dans laquelle le substrat de croissance (42) comprend du saphir.

7. Structure selon la revendication 1, dans laquelle le substrat de croissance (42) a une épaisseur supérieure à 200 microns.

8. Structure selon la revendication 1, dans laquelle le substrat de croissance (42) a une épaisseur supérieure à 500 microns.

9. Structure selon la revendication 1, dans laquelle le matériau de conversion de longueur d'onde (26) comprend des grains de phosphore infusés dans un matériau liant, et dans laquelle au moins une partie de la lumière émise depuis les parois latérales du substrat de croissance (42) alimente les grains luminophore qui ne recouvrent pas la matrice LED (10).

10. Structure selon la revendication 1, dans laquelle la matrice LED (10) émet une lumière bleue et le matériau luminophore émet une lumière luminophore qui se combine avec la lumière bleue.

11. Procédé de formation d'une structure électroluminescente comprenant les étapes consistant à :
fournir une plaquette de substrat de croissance (42) ayant une première surface (43) et une deuxième surface (44) opposée à la première surface (43) ;
former une pluralité d'éléments optiques dans la deuxième surface (44) de la plaquette de substrat de croissance (42) ;
après formation de la pluralité d'éléments optiques, faire croitre des couches épitaxiales (28, 30, 32) sur la première surface (43) de la plaquette de substrat de croissance pour former une diode électroluminescente (LED), la LED ayant une couche active (30) qui émet de la lumière, la couche active (30) ayant une troisième surface faisant face à la plaquette de substrat de croissance (42) ;
former des électrodes d'anode (12) et de cathode (14) réfléchissantes qui couvrent une partie significative d'une surface inférieure de la diode électroluminescente (10) et qui sont configurées pour être directement couplées aux électrodes d'un boîtier ;
déposer une couche réfléchissante sur la plaquette de substrat de croissance (42) pour recouvrir la surface extérieure desdits au moins un élément optiques ;
séparer la plaquette de substrat de croissance (42) pour former des matrices LED individuelles (10) ayant une partie de substrat de croissance (42), dans lequel chaque partie de substrat de croissance (42) a au moins un des éléments optiques, ledit au moins un des éléments optiques redirigeant une majorité de lumière émise depuis la troisième surface de la couche active pour sortir de la matrice LED (10) à travers les parois latérales de la partie de substrat de croissance (42),
**caractérisé par** l'étape consistant à,
monter l'une des matrices LED (10) dans une coupelle réfléchissante (22) ; et
déposer un matériau de conversion de longueur d'onde (25, 26) dans la coupelle (22) recouvrant un dessus et des côtés de la matrice LED (10).
